# EUROPÄISCHE PATENTSCHRIFT

(11) **EP 0 784 102 B1**
(45) Veröffentlichungstag und Bekanntmachung des Hinweises auf die Patenterteilung: **12.12.2001**
(21) Anmeldenummer: 96810020.6
(22) Anmeldetag: 10.01.1996
(51) Int. Cl.: C23C 14/30

(54) **Verfahren und Vorrichtung zum Beschichten einer Substratfläche**
Process and apparatus for coating a substrate surface
Procédé et dispositif pour revêtir la surface d'un substrat

(43) Veröffentlichungstag der Anmeldung: 16.07.1997
(73) Patentinhaber: Alcan Technology & Management AG, 8212 Neuhausen am Rheinfall (CH)
(72) Erfinder: Lohwasser, Wolfgang, CH-8200 Schaffhausen (CH); Wisard, André, CH-8106 Adlikon (CH)

(56) Entgegenhaltungen:
- EP-A- 0 384 617
- EP-A- 0 545 863
- DE-A- 4 239 511
- THIN SOLID FILMS, Bd. 256, Nr. 1/02, 1.Februar 1995, Seiten 124-135, XP000495265 KAJIOKA H ET AL: "LOW VOLTAGE-HIGH CURRENT DISCHARGE OF TI VAPOUR IN HIGH VACUUM"

## Beschreibung

Die Erfindung betrifft ein Verfahren und eine Vorrichtung, zum Beschichten einer Substratfläche nach dem Oberbegriff der Ansprüche 1 bzw. 7.

Beim Beschichten von elektrisch nicht leitenden Substratmaterialien mit elektrisch nicht leitenden Schichten mit Elektronenstrahlverfahren treten Aufladungsprobleme auf. Diese sind darauf zurückzuführen, dass die zur Aufrechterhaltung des Verdampfungsprozesses durch die Elektronenstrahlkanone eingestrahlten Elektronen nicht definiert abgeführt werden, da die elektrischen Ladungen nicht über die elektrisch isolierenden Beschichtungs- und Substratmaterialien abfliessen können und ein Ladungsabfluss auch über die nach einer gewissen Zeit elektrisch isolierend beschichteten Wände der Vakuumkammer nicht mehr möglich ist.

Die Aufladungsphänomene äussern sich beispielsweise in einer ungleichmässigen Fokussierung des Elektronenstrahles, in einer undefinierten Strahlführung als Folge undefiniert auftretender elektrostatischer Felder sowie in einer Aufladung des Substratmaterials, was insbesondere bei der Bandbeschichtung von Kunststoffolien zu erheblichen Wickelproblemen führen kann. Durch die elektrostatischen Aufladungen können auch Entladungsphänomene auftreten, die zu Löchern (pinholes) in der Folie führen. Der Ladungsaufbau kann sich ausserdem in einem Verblocken der Folie äussern.

Aus der EP-A-0545863 ist ein Verfahren der eingangs genannten Art bekannt, bei welchem ein ionisierender Elektronenstrahl niedriger Energie unter Bildung eines Plasmas durch die Gasphase aus anorganischem Material auf eine Anode geleitet wird. Die hierbei auftretenden Gasentladungen führen zu einem Abfluss der elektrischen Ladungen. Der Nachteil dieses vorbekannten Verfahrens wird darin gesehen, dass in der Vakuumkammer eine zweite Elektronenstrahlkanone angeordnet werden muss.

Aus dem Artikel von H. Kajioka et al, "Low voltage-high current discharge of Ti vapour in high vacuum", THIN SOLID FILMS 256 (1995), Nos. 1/2 ist eine Vorrichtung der eingangs genannten Art für die Verdampfung von Ti bekannt.

Angesichts dieser Gegebenheiten haben sich die Erfinder die Aufgabe gestellt, ein Verfahren und eine Vorrichtung der eingangs genannten Art derart auszugestalten, dass der Aufbau unerwünschter elektrischer Ladungen innerhalb der Vakuumkammer mit einfachen Mitteln wirksam verhindert werden kann.

Zur erfindungsgemässen Lösung der Aufgabe führt ein Verfahren und eine Vorrichtung mit dem Merkmalen der Ansprüche 1 bzw. 7.

Zur Aufrechterhaltung der elektrischen Leitfähigkeit an der Oberfläche der Anode wird diese auf eine oberhalb der Kondensationstemperatur des verdampften anorganischen Materials liegende Temperatur aufgeheizt. Hierbei wird die Anode zweckmässigerweise elektrisch über einen zur Einkopplung des Heizstromes in den Stromkreis geschalteten Transformator beheizt.

Unter optimalen Prozessparametern fliesst durch die Anodenspannungsversorgung jeweils ein dem Emissionsstrom der Elektronenstrahlkanone betragsmässig gleicher Strom. Dies bedeutet, dass über die Anode die gesamte über die Elektronenstrahlkanone eingestrahlte Ladungsmenge abfliesst.

Insbesondere im Verlauf langer Beschichtungszyklen kann sich der Gasdruck derart verändern, dass nicht mehr der volle Emissionsstrom über die Anode abfliesst. Es kann sich deshalb als vorteilhaft erweisen, den Druck in der Vakuumkammer zur Stabilisierung der Gasentladung zusätzlich über die Variation des Gaseinlasses konstant zu halten. Die Steuerung erfolgt bevorzugt automatisch über einen geschlossenen Regelkreis, wobei üblicherweise ein Gasdruck von 10⁻³ bis 2 . 10⁻⁴ mbar eingestellt wird.

Bei einer zur Durchführung des erfindungsgemässen Verfahrens geeigneten Vorrichtung ist die Anode im Bereich des zu verdampfenden anorganischen Materials bevorzugt ausserhalb der direkten Verdampfungszone angeordnet.

Das zu verdampfende anorganische Material wird üblicherweise in einem Tiegel bereitgestellt, kann aber auch beispielsweise auf einer wassergekühlten Platte angeordnet sein.

Da die Anode hohen Temperaturen ausgesetzt ist, muss sie aus einem entsprechend temperaturbeständigen Werkstoff gefertigt sein. Die Anode ist daher bevorzugt als Draht, Stab, Rohr, Gitter oder Netz aus Wolfram, Tantal, Molybden oder Graphit ausgebildet.

Das erfindungsgemässe Verfahren eignet sich insbesondere zur Beschichtung von Kunststoffolien für die Verpackungsindustrie und ganz allgemein zum Beschichten von elektrisch nicht leitenden Substratmaterialien mit elektrisch nicht leitenden Schichten ausgehend von elektrisch nicht leitenden Beschichtungsmaterialien.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt schematisch in
- - Fig. 1: eine Prinzipskizze einer Beschichtungsanordnung;
- - Fig. 2: eine Prinzipskizze einer Anordnung zur Beschichtung von Folienbändern;
- - Fig. 3: einen Teilschnitt durch eine beschichtete Verbundfolie.

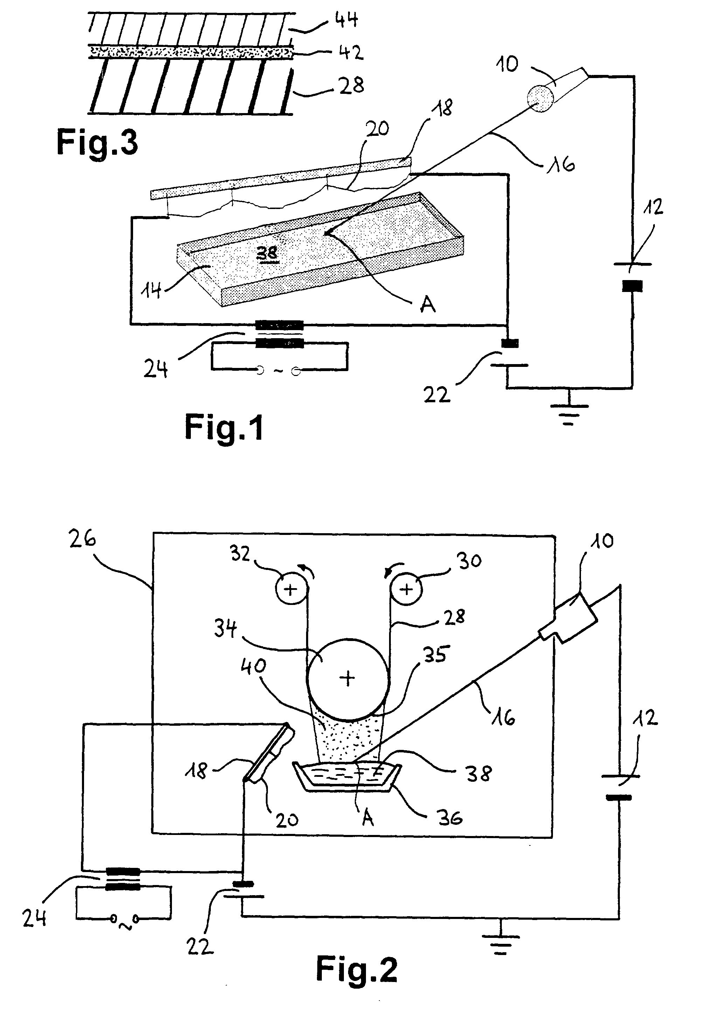

Gemäss Fig. 1 ist eine Hochspannungs-Elektronenstrahlkanone 10 an eine Gleichstrom-Hochspannungsversorgung 12 angeschlossen. Der von der Elektronenstrahlkanone 10 emittierte Elektronenstrahl 16 wird auf eine wassergekühlte Platte 14 mit dem zu verdampfenden anorganischen Material 38 gelenkt, wobei der Elektronenstrahl 16 bzw. dessen Auftreffpunkt A auf der Platte 14 scannend über die Plattenoberfläche bewegt wird, d.h. der Eletronenstrahl fährt die Oberfläche des zu verdampfenden anorganischen Materials programmgesteuert ab. Hierbei erhitzt sich das anorganische Material durch die Energie des auftreffenden Elektronenstrahls 16 und verdampft.

Im Bereich der Platte 14 mit dem zu verdampfenden anorganischen Material 38 ist eine Anode 20 -- beispielsweise in der Form eines Wolfram-Filaments -- auf einer ebenfalls wassergekühlten Halterung 18 angeordnet. Die Anode 20 ist an eine Gleichstrom-Anodenspannungsversorgung 22 angeschlossen. Ueber einen Tranformator 24 erfolgt die Einkopplung des Anodenheizstromes.

Nach der Ausführungsform von Fig. 2 wird innerhalb einer Vakuumkammer 26 eine Kunststoffolie 28 von einer ersten Rolle 30 abgewickelt und über eine Walze 34 gezogen. Die auf der Walze 34 als Substratträger aufliegende Kunststoffolie 28 bildet im Arbeitsbereich die Substratfläche 35. Nach der Beschichtung wird die Kunststoffolie 28 auf eine weitere Rolle 32 aufgewickelt. Allfällige Umlenkrollen sind aus Gründen der besseren Uebersicht nicht eingezeichnet.

In einem Tiegel 36 befindet sich das zu verdampfende anorganische Material 38, welches vom Elektronenstrahl 16 der scannenden Hochspannungs-Elektronenstrahlkanone 10 erhitzt wird, wodurch sich eine Gasphase 40 aus anorganischem Material 38 ausbildet.

Zwischen dem Auftreffpunkt A des Elektronenstrahles 16 auf dem anorganischen Material 38 im Tiegel 36 und dem beheizten Anodendraht 20 entsteht bei geeignet gewählten Prozessparametern im Gas, das über ein in der Zeichnung nicht dargestelltes Gaseinlassystem in die Vakuumkammer zudosiert wird und in der Gasphase 40 aus dem anorganischen Material 38 eine Gasentladung.

Durch die Aufheizung der Anode auf eine Temperatur oberhalb der Kondensationstemperatur des verdampften anorganischen Materials 38 wird verhindert, dass die Anode 20 selber beschichtet. Dadurch kann die Gasentladung über die gesamte Prozesszeit aufrechterhalten werden. Ueber die Gasentladung fliessen nun die durch die Elektronenstrahlkanone 10 eingestrahlten elektrischen Ladungen zur Erde hin ab, so dass ein stabiler geschlossener Stromkreislauf entsteht und sich keine weiteren elektrischen Ladungen mehr an unerwünschten Orten ansammeln können. Zudem lädt sich das Beschichtungsmaterial nicht mehr elektrostatisch auf, so dass keine Strahldefokussierungen auftreten können.

Wie bereits erwähnt, fliesst bei geeignet gewählten Prozessparametern durch die Gleichstrom-Anodenspannungsversorgung 22 ein betragsmässig dem Emissionsstrom der Elektronenstrahlkanone 10 entsprechender Strom.

Für nicht reaktive Beschichtungsprozesse eignen sich alle für den Prozess inerten Gase, insbesondere Edelgase, bevorzugt Argon. Wenn ein reaktiver Aufdampfprozess durchgeführt wird, kann das für die Gasentladung benötigte Gas natürlich auch das jeweilige Reaktivgas sein, ggf. in Kombination mit einem Inertgas.

In den Fig. 1 und 2 sind aus Gründen der besseren Uebersicht alle Hilfsstromversorgungen und Vorrichtungen für die Beheizung der Kathode der Elektronenstrahlkanone 10 weggelassen. Ebenfalls in der Zeichnung im einzelnen nicht dargestellt ist ein regelbares Gaseinlassystem mit Gasverteilungssystem in der Nähe des anorganischen Aufdampfmaterials sowie ein Druckmessystem.

Als verdampfbare anorganische Materialien sind alle an sich bekannten Werkstoffe geeignet, die nach dem Abscheiden aus der Gasphase, ohne oder mit einer chemischen Reaktion, eine als Gas- und Feuchtigkeitsbarriere dienende Schicht bilden. Als Beispiele seien Siliciummonoxid, Siliciumdioxid, Titanoxid, Zirkonoxid, Aluminiumoxid sowie Magnesiumoxid erwähnt. Diese Oxide können auch gemischt oder dotiert sein. Weiter können die Metalle verdampft werden und während des Beschichtungsverfahrens kann wenigstens ein reaktives Gas, beispielsweise Sauerstoff, Stickstoff, Wasserstoff und/oder Acetylen, zugeführt werden. Dabei können die entsprechenden Oxide, Nitride, Karbide oder Mischkomponenten entstehen. Selbstverständlich können auch reaktive Gase zugeführt werden, wenn das zu verdampfende Material bereits als Oxid, Nitrid und/oder Karbid vorliegt.

Die an die Hochspannungs-Elektronenstrahlkanone 10 angelegte elektrische Spannung liegt bevorzugt bei wenigstens 5 kV, insbesondere bei wenigstens 10 kV, bei einer Stromstärke von einigen Ampère. Die Hochspannungs-Elektronenstrahlkanone arbeitet beispielsweise mit einer Energie von 35 KW.

Mit dem erfindungsgemässen Verfahren werden auf dem Substrat Niederschlagsraten erzielt, die wenigstens bei 0,01 µm/sec liegen, vorzugsweise jedoch im Bereich von 0,5 bis 1 µm/sec.

Vorzugsweise werden mit dem erfindungsgemässen Verfahren zu beschichtende Substratflächen, insbesondere Kunststofffolien, während des Beschichtungsvorgangs bewegt. Die Geschwindigkeit von durchlaufenden Kunststoffolien liegt zweckmässig im Bereich von 1 bis 10 m/sec, insbesondere bei 3 bis 6 m/sec. Die Kunststoffolien bestehen beispielsweise aus Polyester (PET), Polyethylen (PE), Polypropylen (PP) oder Polyamid (PA).

Die in Fig. 3 dargestellte beschichtete Verbundfolie umfasst die Basis-Kunststoffolie 28, eine als Permeationssperre aufgedampfte anorganische Schicht 42 sowie eine siegelbare Folie 44, welche nach dem Bedampfen aufgebracht worden ist.

### Beispiel

Zur Herstellung von transparenten Filmen mit guten Gas- und Wasserdampfbarrieren werden heute mit SiOₓ bedampfte Kunststoffilme verwendet. Die Bedampfung mit SiOₓ erfolgt bei hohen Beschichtungsraten zweckmässigerweise mit Elektronenstrahlen. Dieser Prozess kann mit dem erfindungsgemässen Verfahren bzw. der Vorrichtung beschleunigt und stabilisiert werden, wobei am Substrat keinerlei Aufladungsphänomene wie Pinholes durch Ueberschläge oder Verblockung der Folie durch Aufladung auftreten.

Die Beschichtungsbreite beträgt beispielsweise 700 mm. Die zu beschichtende Folie aus Polyester weist eine Dicke von 12 µm auf. Der mit SiO-Granulat gefüllte Tiegel ist beispielsweise 840 mm lang. Als Anode dient ein beispielsweise 1 mm dicker Wolframdraht, der isoliert über dem Tiegel etwas ausserhalb der direkten Verdampfungszone angebracht ist. Ebenfalls in der Nähe des Tiegels befindet sich ein Gasverteilungsrohr, in das das Gas eingelassen und sodann über dünne Bohrungen in die Zone der Gasentladung abgegeben wird. Das Gas -- beispielsweise Argon -- wird druckgeregelt unter Einhaltung eines konstanten Druckes von beispielsweise 5. 10⁻⁴ mbar in die Vakuumkammer dosiert. Die Gleichstrom-Anodenspannungsversorung arbeitet mit einer Gleichspannung von 250 V, die Beheizung des Wolframdrahtes der Anode erfolgt mit Hilfe eines 50 Hz-Wechselstromes einer Stärke von 30 A. Die Beschleunigungsspannung der Elekronenstrahlkanone beträgt 35 kV, der Emissionsstrom der Kanone liegt bei 1,2 A. Dieser Strom fliesst auch über den Wolframdraht der Anode ab. Mit den gewählten Parametern beträgt die Schichtdicke auf der Folie bei einer Beschichtungsgeschwindigkeit von 600 m/min 50 nm, was zur Erzielung einer guten Barriereschicht ausreicht. Diese Aufdampfgeschwindigkeit ist mindestens doppelt so hoch wie die ohne starke Schädigung des Substratfilmes mit einer konventionellen Beschichtungsanlage erreichbare Aufdampfgeschwindigkeit. Die Folie lässt sich einwandfrei ohne Aufladungsprobleme wickeln. Es treten auch keine elektrostatischen Durchschläge durch die Folie auf.

## Patentansprüche

1. Verfahren zum Beschichten einer Substratfläche (35) mit einer elektrisch nicht leitenden Schicht aus anorganischem Material (38), welches in einer auf wenigstens 10⁻³ mbar evakuierten Vakuumkammer (26) durch Beaufschlagung mit einem Elektronenstrahl (16) aus einer Hochspannungs-Elektronenstrahlkanone (10) verdampft und auf der Substratfläche (35) niedergeschlagen wird,
**dadurch gekennzeichnet, dass** zwischen dem Auftreffpunkt (A) des Elektronenstrahls (16) auf dem zu verdampfenden, elektrisch nicht leitenden anorganischen Material (38) und einer Anode (20) eine das Abfliessen der durch die Hochspannungs-Elektronenstrahlkanone (10) eingestrahlten elektrischen Ladungen über die Anode (20) bewirkende Gasentladung erzeugt wird, wobei die Anode (20) zur Aufrechterhaltung der elektrischen Leitfähigkeit an ihrer Oberfläche auf eine oberhalb der Kondensationstemperatur des verdampften anorganischen Materials liegende Temperatur aufgeheizt wird.

2. Verfahren nach Anspruch 1, **dadurch gekennzeichnet, dass** die Anode (20) über einen Transformator (24) elektrisch beheizt wird.

3. Verfahren nach Anspruch 1 oder 2, **dadurch gekennzeichnet, dass** während des Beschichtens ein Gas in die Vakuumkammer (26) eingeleitet wird.

4. Verfahren nach einem der Ansprüche 1 bis 3, **dadurch gekennzeichnet, dass** zur Stabilisierung der Gasentladung der Druck in der Vakuumkammer (26) konstant gehalten wird.

5. Verfahren nach Anspruch 4, **dadurch gekennzeichnet, dass** der Gasdruck automatisch über einen geschlossenen Regelkreis konstant gehalten wird.

6. Verfahren nach einem der Ansprüche 1 bis 5, **dadurch gekennzeichnet, dass** der Druck in der Vakuumkammer (26) auf 10⁻³ bis 2.10⁻⁴ mbar eingestellt wird.

7. Vorrichtung zur Durchführung des Verfahrens nach einem der Ansprüche 1 bis 6, mit einer Vakuumkammer (26), einer Hochspannungs-Elektronenstrahlkanone (10), einer Einrichtung (14,36) zur Aufnahme von zu verdampfendem Material und einer im Bereich der Einrichtung (14,36) angeordneten Anode (20), **dadurch gekennzeichnet, dass** die Anode (20) auf eine oberhalb der Kondensationstemperatur des zu verdampfenden Materials liegende Temperatur aufheizbar ist.

8. Vorrichtung nach Anspruch 7, **dadurch gekennzeichnet, dass** die Anode (20) ausserhalb der direkten Verdampfungszone angeordnet ist.

9. Vorrichtung nach Anspruch 7 oder 8, **dadurch gekennzeichnet, dass** das zu verdampfende anorganische Material (38) in einem Tiegel (36) oder auf einer wassergekühlten Platte (14) angeordnet ist.

10. Vorrichtung nach einem der Ansprüche 7 bis 9, **dadurch gekennzeichnet, dass** die Anode (20) als Draht, Stab, Rohr, Gitter oder Netz aus Wolfram, Tantal, Molybden oder Graphit ausgebildet ist.

11. Anwendung des Verfahrens nach einem der Ansprüche 1 bis 6 zur Beschichtung von Kunststoffolien (28) für die Verpackungsindustrie.

12. Anwendung des Verfahrens nach einem der Ansprüche 1 bis 6 zum Beschichten von elektrisch nicht leitenden Substratmaterialien mit elektrisch nicht leitenden Schichten.

## Claims

1. Process for coating a substrate surface (35) with an electrically non-conductive layer of inorganic material (38) which is evaporated in a vacuum chamber (26) evacuated to at least 10⁻³ mbar by bombardment with an electron beam (16) from a high-voltage electron-beam gun (10) and deposited on the substrate surface (35), **characterised in that** a gas discharge is produced between the point of impingement (A) of the electron beam (16) on the electrically non-conductive inorganic material (38) to be evaporated and an anode (20) in such a manner that the electric charges emitted by the high-voltage electron-beam gun (10) flow off via the anode (20), the anode (20) being heated to a temperature in excess of the condensation temperature of the evaporated inorganic material in order to maintain the electrical conductivity on its surface.

2. Process according to claim 1, **characterised in that** the anode (20) is heated electrically by means of a transformer (24).

3. Process according to claim 1 or claim 2, **characterised in that** a gas is introduced into the vacuum chamber (26) during coating.

4. Process according to one of claims 1 to 3, **characterised in that** the pressure in the vacuum chamber (26) is kept constant in order to stabilise the gas discharge.

5. Process according to claim 4, **characterised in that** the gas pressure is kept constant automatically by means of a closed-loop control circuit.

6. Process according to one of claims 1 to 5, **characterised in that** the pressure in the vacuum chamber (26) is set at 10⁻³ to 2 · 10⁻⁴ mbar.

7. Device for carrying out the process according to one of claims 1 to 6, comprising a vacuum chamber (26), a high-voltage electron-beam gun (10), a device (14, 36) for receiving material to be evaporated and an anode (20) arranged in the region of the device (14, 36), **characterised in that** the anode (20) can be heated to a temperature in excess of the condensation temperature of the material to be evaporated.

8. Device according to claim 7, **characterised in that** the anode (20) is arranged outside the actual evaporation zone.

9. Device according to claim 7 or claim 8, **characterised in that** the inorganic material (38) to be evaporated is arranged in a crucible (36) or on a water-cooled plate (14).

10. Device according to one of claims 7 to 9, **characterised in that** the anode (20) is in the form of a wire, rod, tube, mesh or net made of tungsten, tantalum, molybdenum or graphite.

11. Use of the process according to one of claims 1 to 6 for coating plastic films (28) for the packaging industry.

12. Use of the process according to one of claims 1 to 6 for coating electrically non-conductive substrate materials with electrically non-conductive layers.

## Revendications

1. Procédé de revêtement d'une surface de substrat (35) par une couche électriquement non conductrice d'un matériau minéral (38) qui est vaporisé dans une chambre sous vide (26) placée sous un vide d'au moins 10⁻³ mbar par l'action d'un faisceau d'électrons (16) provenant d'un canon à électrons (10) sous haute tension, et est déposé à la surface (35) du substrat,
**caractérisé en ce que**
entre le point d'incidence (A) du faisceau d'électrons (16) sur le matériau minéral (38) à vaporiser et électriquement non conducteur et une anode (20), on crée une décharge dans le gaz qui a pour effet l'évacuation des charges électriques projetées par le canon à électrons (10) sous haute tension par l'intermédiaire de l'anode (20), tandis que pour maintenir la conductivité électrique de l'anode (20) à sa surface, l'anode est chauffée à une température située au-dessus de la température de condensation du matériau minéral à vaporiser.

2. Procédé selon la revendication 1, **caractérisé en ce que** l'anode (20) est chauffée électriquement par l'intermédiaire d'un transformateur (24).

3. Procédé selon la revendication 1 ou 2, **caractérisé en ce que** pendant le revêtement, un gaz est introduit dans la chambre sous vide (26).

4. Procédé selon l'une des revendications 1 à 3, **caractérisé en ce que** pour stabiliser la décharge dans le gaz, la pression dans la chambre sous vide (26) est maintenue constante.

5. Procédé selon la revendication 4, **caractérisé en ce que** la pression de gaz est maintenue constante de façon automatique par l'intermédiaire d'une boucle de régulation fermée.

6. Procédé selon l'une des revendications 1 à 5, **caractérisé en ce que** la pression de la chambre sous vide (26) est réglée entre 10⁻³ et 2 . 10⁻⁴ millibars.

7. Dispositif en vue de la mise en oeuvre du procédé selon l'une des revendications 1 à 6, qui comporte une chambre sous vide (26), un canon à électrons (10) sous haute tension, un dispositif (14, 36) pour la réception d'un matériau à vaporiser et une anode (20) disposée dans la région du dispositif (14, 36), **caractérisé en ce que** l'anode (20) peut être chauffée à une température qui est située au-dessus de la température de condensation du matériau à vaporiser.

8. Dispositif selon la revendication 7, **caractérisé en ce que** l'anode (20) est disposée à l'extérieur de la zone de vaporisation directe.

9. Dispositif selon la revendication 7 ou 8, **caractérisé en ce que** le matériau minéral à vaporiser (38) est placé dans un creuset (36) ou sur une plaque (14) refroidie par eau.

10. Dispositif selon l'une des revendications 7 à 9, **caractérisé en ce que** l'anode (20) est configurée en fil, en barre, en tube, en grille ou en treillis en tungstène, tantale, molybdène ou graphite.

11. Utilisation du procédé selon l'une des revendications 1 à 6 pour revêtir des feuilles (28) en matière synthétique destinées à l'industrie de l'emballage.

12. Utilisation du procédé selon l'une des revendications 1 à 6 pour revêtir des matériaux de substrat électriquement non conducteurs de couches électriquement non conductrices.
